# EUROPÄISCHE PATENTSCHRIFT

(11) **EP 1 535 351 B1**
(45) Veröffentlichungstag und Bekanntmachung des Hinweises auf die Patenterteilung: **03.05.2006**
(21) Anmeldenummer: 03794878.3
(22) Anmeldetag: 14.08.2003
(51) Int. Cl.: H01L 43/06, G01R 33/07

(54) **HALL-SENSOR UND VERFAHREN ZU DESSEN BETRIEB**
HALL SENSOR AND METHOD FOR THE OPERATION THEREOF
CAPTEUR HALL ET PROCEDE POUR LE FAIRE FONCTIONNER

(30) Priorität: 02.09.2002 DE 10240404
(43) Veröffentlichungstag der Anmeldung: 01.06.2005
(73) Patentinhaber: austriamicrosystems AG, 8141 Unterpremstätten (AT)
(72) Erfinder: MUELLER, Thomas, A-8010 Graz (AT)
(74) Vertreter: Epping - Hermann - Fischer
(86) Internationale Anmeldenummer: PCT/EP2003/009043
(87) Internationale Veröffentlichungsnummer: WO 2004/025743

(56) Entgegenhaltungen:
- EP-A- 0 735 600
- CH-A- 663 686
- DE-A- 4 308 375
- US-A- 3 825 777
- MANI R G ET AL: "TEMPERATURE-INSENSITIVE OFFSET REDUCTION IN A HALL EFFECT DEVICE" APPLIED PHYSICS LETTERS, AMERICAN INSTITUTE OF PHYSICS. NEW YORK, US, Bd. 64, Nr. 23, 6. Juni 1994 (1994-06-06), Seiten 3121-3123, XP000449593 ISSN: 0003-6951

## Beschreibung

Die Erfindung betrifft einen Hall-Sensor auf einem Halbleitersubstrat sowie ein Betriebsverfahren für den Hall-Sensor.

Aus der Druckschrift US 4929993 sind Hall-Sensoren auf Siliziumsubstrat bekannt, bei denen eine n-dotierte Zone in eine p-dotierte Wanne eingebracht ist. Die n-dotierte Zone bildet dabei die aktive Zone des Hall-Sensors, also das Hall-Plättchen. Das Hall-Plättchen weist vier äußere Anschlüsse auf, wobei jeweils gegenüberliegende Anschlüsse für das Einspeisen des Steuerstromes bzw. das Auslesen der Hall-Spannung vorgesehen sind.

Die bekannten Hall-Sensoren haben den Nachteil, daß sie zur Messung sehr kleiner statischer Magnetfelder weniger geeignet sind, da sie auch bei Magnetfeld = 0 aufgrund von Materialinhomogenitäten eine Hall-Spannung in Form einer Fehlspannung erzeugen.

Um Fehlspannungen (diese sind auch bekannt unter dem Namen Offset) zu reduzieren, ist es aus der Druckschrift P.J.A. Munter, A low Offset spinning-current hall plate, Sensors & Actuators A, A22 (1990) 743-746 bekannt, Hall-Sensoren mit einem speziellen Betriebsverfahren zu betreiben. Dazu wird an das Hall-Plättchen ein sich im Laufe der Zeit um die Achse des Magnetfelds drehender Steuerstrom angelegt. Da während der Drehung der Stromrichtung um jeweils 90 Grad die Fehlspannung ihr Vorzeichen wechselt, kann durch Addieren von um 90 Grad verdreht gemessenen Fehlspannungspaaren die Gesamtfehlspannung bis auf eine Restfehlspannung kompensiert werden.

Bei einem Hall-Plättchen bestehend aus einer n- oder p-dotierten Zone, eingebettet in einem Halbleitersubstrat des jeweils anderen Leitungstyps wird die Größe der Restfehlspannung durch einen im Folgenden beschriebenen Effekt beeinflußt. Es entsteht eine Raumladungszone zwischen dem Hall-Plättchen und seiner Umgebung. Bei Einprägen eines Steuerstroms in das Hall-Plättchen entsteht über eine Richtung des Hall-Plättchens ein Spannungsabfall, der die Breite der Raumladungszone und mithin die Breite des Hall-Plättchens, also die letztlich aktive Zone im Halbleitermaterial, in der der Hall-Effekt stattfindet, variiert.

Es ist daher Aufgabe der vorliegenden Erfindung, einen Hall-Sensor anzugeben, der so betrieben werden kann, daß die Restfehlspannung reduziert ist.

Diese Aufgabe wird gelöst durch einen Hall-Sensor nach Patentanspruch 1 sowie ein Verfahren zu dessen Betrieb nach Patentanspruch 4. Vorteilhafte Ausgestaltungen der Erfindung sind den weiteren abhängigen Patentansprüchen zu entnehmen.

Es wird ein Hall-Sensor angegeben, der auf einem Halbleitersubstrat angeordnet ist. Es ist ein Hall-Plättchen gebildet aus einer Zone eines Leitungstyps in dem Substrat. An das Hall-Plättchen grenzt eine Zone des anderen Leitungstyps an. Die Zone des anderen Leitungstyps und das Hall-Plättchen sind lediglich durch eine Raumladungszone voneinander getrennt. Das Hall-Plättchen ist mit Kontakten versehen, die zur Einspeisung eines Steuerstroms geeignet sind. Ferner ist die Zone des anderen Leitungstyps mit Kontakten zur Einspeisung eines Kompensationsstroms versehen.

Das Hall-Element hat den Vorteil, daß durch die Bereitstellung der Möglichkeit, einen Kompensationsstrom in einen an die Raumladungszone angrenzenden Bereich zu speisen, die Dikke der Raumladungszone und mithin die Dicke des Hall-Plättchens positiv beeinflußt werden kann.

Dementsprechend wird ein Verfahren zum Betrieb des Hall-Sensors angegeben, wobei ein Kompensationsstrom parallel zum Steuerstrom fließt, dessen Größe so bemessen ist, daß das Hall-Plättchen eine im wesentlichen konstante Dicke aufweist.

In einer ersten Ausführungsform des Hall-Elements ist das Hall-Plättchen zwischen zwei Zonen des anderen Leitungstyps angeordnet. Diese Ausführungsform hat den Vorteil, daß es möglich ist, die Dicke des Hall-Plättchens von beiden Seiten her mittels Kompensationsstrom zu beeinflussen.

In einer anderen Ausführungsform ist das Hall-Plättchen an der Oberfläche des Substrats angeordnet. Ferner ist die Zone des anderen Leitungstyps in ein Substrat eingebettet, welches vom Leitungstyp des Hall-Plättchens ist. Auch in dieser speziellen Designvariante gelingt die Kompensation der Deformierung des Hall-Plättchens aufgrund des Spannungsabfalls durch Einspeisung eines Steuerstroms.

Im folgenden wird die Erfindung anhand von Ausführungsbeispielen und den dazugehörigen Figuren näher erläutert:
Figur 1 zeigt einen Hall-Sensor einer ersten und einer zweiten Ausführungsform in einer Draufsicht.
Figur 2 zeigt einen Hall-Sensor für eine erste und zweite Ausführungsform als Querschnitt entlang der Linie II-II in Figur 1.
Figur 3 zeigt einen Querschnitt entsprechend Figur 2.
Figur 4 zeigt eine erste Ausführungsform eines Hall-Sensors in einem schematischen Querschnitt.
Figur 5 zeigt eine weitere Ausführungsform eines Hall-Sensors in einem schematischen Querschnitt.

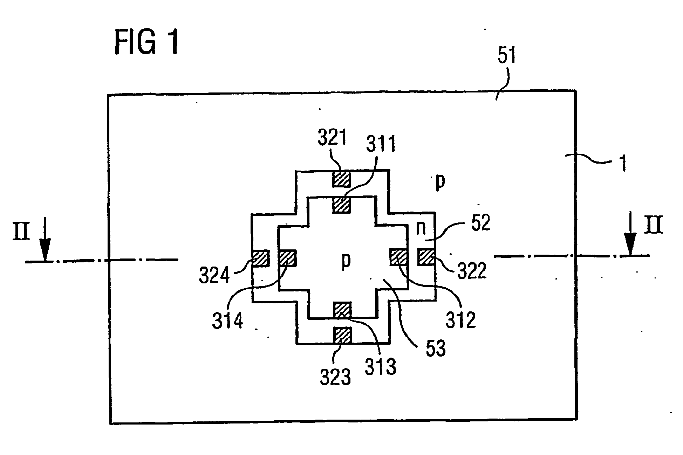

Figur 1 zeigt die Draufsicht auf ein Substrat 1. Das Substrat 1 kann beispielsweise aus Silizium bestehen. Das Substrat 1 bildet eine äußere p-dotierte Zone 51. In einem mittleren Bereich des Substrats 1 ist durch Dotieren eine n-dotierte Zone 52 gebildet. Die Zone 52 hat die Form eines Kreuzes mit vier Kontakten 321, 322, 323, 324 jeweils an den äußeren Enden des Kreuzes. Die Zone 52 kann aber auch die Form eines Quadrates, Rechtecks oder Kreises aufweisen. Im Inneren der Zone 52 ist durch p-Dotierung eine p-dotierte Zone 53 gebildet. Die Zone 53 ist ähnlich zur Zone 52 und die Außenkanten der Zone 53 sind jeweils zu entsprechenden Außenkanten der Zone 52 parallel. An den der Zone 52 entsprechenden Seitenkanten der Zone 53 sind Kontakte 311, 312, 313, 314 angeordnet. Die Kontakte 311, 312, 313, 314, 321, 322, 323, 324 dienen der Einspeisung von Strömen in die einzelnen Zonen 51, 52, 53 bzw. zur Erfassung einer Hall-Spannung.

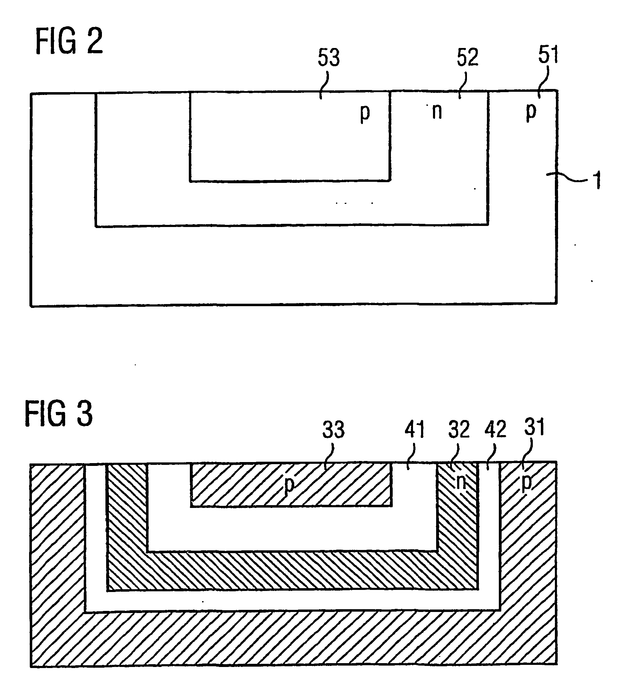

Figur 2 zeigt einen Querschnitt von Figur 1 entlang der Linie II-II. Es sind insbesondere die Tiefenstrukturen der Zonen 51, 52, 53 dargestellt. Die Zone 51 ist eine p-dotierte Zone, die durch das Substrat 1 gebildet wird. In das Substrat 1 durch n-Dotierung eingebettet ist die n-dotierte Zone 52. In die Zone 52 durch p-Dotierung eingebettet ist die p-dotierte Zone 53.

An den Stellen ohne Raumladungszone bleiben gemäß Figur 3 die sich aus den dotierten Zonen 51, 52, 53 gemäß Figur 2 ausbildenden leitenden Zonen 31, 32, 33. Zwischen zwei jeweils entgegengesetzt dotierten Zonen 51, 52; 52, 53 bildet sich jeweils eine Raumladungszone 41, 42 aus. Die Raumladungszonen 41, 42 sind in Figur 3 durch schraffurlose Flächen gekennzeichnet.. An den Stellen, an denen die Kompensation von p-und n-leitenden Ladungsträgern gestoppt ist, bleiben elektrisch leitende Zonen 31, 32, 33 übrig. Dies sind im speziellen entsprechend der p-dotierten Zone 51 die p-leitende Zone 31 bzw. entsprechend der p-dotierten Zone 53 die p-leitende Zone 33 in der Mitte von Figur 3. Die p-leitenden Zonen sind jeweils durch gleichartige Schraffierung gekennzeichnet, Entsprechend der n-dotierten Zone 52 bildet sich die n-leitende Zone 32 aus, welche durch eine zu den p-leitenden Zonen 31, 33 gegenläufige Schraffur gekennzeichnet ist.

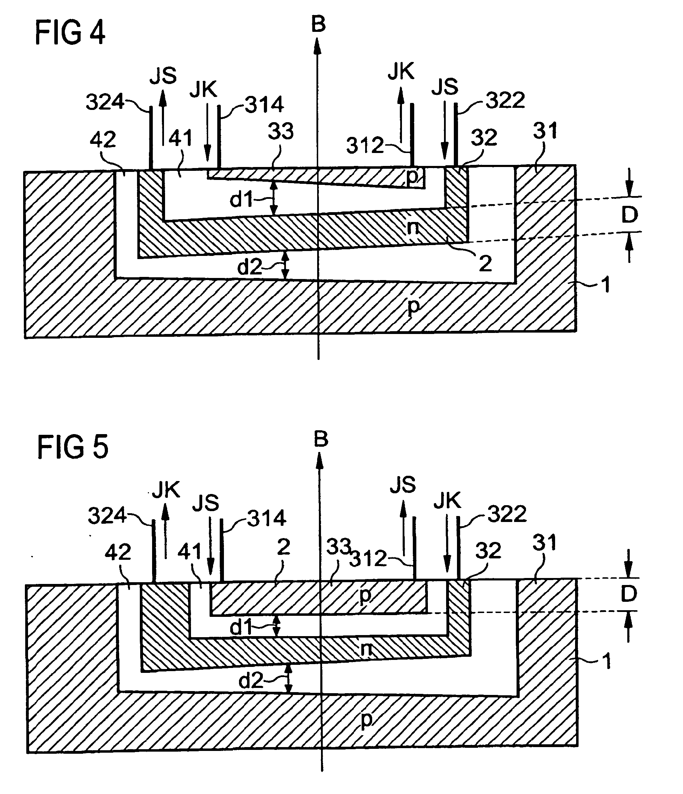

Figur 4 zeigt einen Hall-Sensor gemäß Figur 3, wobei die n-leitende Zone 32 als Hall-Plättchen 2 verwendet wird. Dem entsprechend wird durch die Kontakte 322, 324 ein Steuerstrom IS in die Zone 32 eingespeist, wobei hier nur eine Steuerstromrichtung betrachtet wird. Der Steuerstrom IS bewirkt über die Länge der Zone 32 einen Spannungsabfall, welcher zu einer entsprechenden Variation der Dicke d2 der Raumladungszone 42 führt. Die in Figur 4 gezeigte Stromrichtung führt dazu, daß die Raumladungszone zum rechten Ende hin dicker ist als zum linken Ende hin. Dem entsprechend wird auch die Form der Zone 32 beeinflußt. Diese Beeinflussung der Zone 32 kann nun kompensiert werden, indem in der p-leitenden Zone 33 ein Kompensationsstrom IK fließt. Der Kompensationsstrom IK wird durch die Kontakte 312, 314 in die Zone 33, welche p-leitend ist, eingespeist. Der Kompensationestrom IK verläuft parallel zum Steuerstrom IS. Durch den Kompensationsstrom IK wird wiederum die Dicke der Raumladungszone 41 zwischen der Zone 33 und dem Hall-Plättchen 2 beeinflußt. Der Kompensationsstrom IK führt dazu, daß die Dicke der Raumladungszone 41 zum linken Ende hin größer ist als zum rechten Ende hin. Der Dickenverlauf der Raumladungszonen 41, 42 ist also genau entgegengesetzt. Daraus resultiert bei geeigneter Wahl des Stromes IK, daß die Dicke D der Zone 32, also die Dicke D des Hall-Plättchens 2, über ihre gesamte Länge im wesentlichen konstant gehalten werden kann, weswegen hier in besonders vorteilhafter Weise die Restfehlspannung reduziert werden kann.

In Figur 4 ist noch schematisch die Richtung des zu messenden Magnetfeldes B gezeigt.

Figur 5 zeigt eine Darstellung eines Hall-Sensors entsprechend Figur 4, mit dem Unterschied, daß als Hall-Plättchen 2 nicht die Zone 32, sondern die Zone 33, welche p-dotiert ist, verwendet wird. Entsprechend wird durch die Kontakte 312, 314 ein Steuerstrom IS in die Zone 33 gespeist. Die unterhalb der Zone 33 liegende, n-leitende Zone 32 wird nun mit einem Kompensationsstrom IK mittels der Kontakte 322, 324 beaufschlagt. Der Kompensationsstrom IK verläuft, wie schon in Figur 4 gezeigt, parallel zum Steuerstrom IS. Die Spannung zwischen Zone 32 und Zone 33 ist an jedem Ort nahezu gleich, weswegen die Raumladungszone 41 nahezu eine konstante Dicke d1 hat. Die Dicke d1 ist proportional zur Wurzel aus der Spannung zwischen der Zone 32 und der Zone 33.

Daraus resultiert, daß auch die Dicke der Zone 33, welche das Hall-Plättchen 2 darstellt, über ihre Länge im wesentlichen konstant ist, so daß auch hier eine positive Beeinflussung der Fehlspannung resultiert. In Figur 5 ist noch gezeigt, wie durch den Einfluß des Kompensationsstroms IK die Dicke d2 der Raumladungszone 42 zwischen der Zone 32 und der Zone 31 über ihre Länge beeinflußt wird. Die Variation der Dicke d2 der Raumladungszone 42 hat jedoch keinen nennenswerten Einfluß auf das Hall-Plättchen 2.

Die in den beschriebenen Beispielen verwendeten Dotierungen können beispielsweise zwischen 1 x 10¹⁴ cm⁻³ und 1 x 10¹⁸ cm⁻³ liegen und betragen typischerweise 5 x 10¹⁶ cm⁻³. Die verwendeten Ströme können beispielsweise zwischen 0,1 und 10 mA liegen und betragen typischerweise 1 mA.

Die folgende Erfindung beschränkt sich nicht auf Hall-Sensoren in.Siliziumsubstraten, sondern läßt sich auf alle geeigneten Halbleitermaterialien übertragen.

## Patentansprüche

1. Hall-Sensor auf einem Halbleitersubstrat (1),
- bei dem ein Hall-Plättchen (2) gebildet wird aus einer Zone (33, 32) eines Leitungstyps,
- bei dem eine an das Hall-Plättchen (2) angrenzende, durch eine Raumladungszone (41) davon getrennte Zone (33, 32) des anderen Leitungstyps vorgesehen ist,
- und bei dem das Hall-Plättchen mit Kontakten (311, 312, 313, 314, 321, 322, 323, 324) zur Einspeisung eines Steuerstroms (IS) versehen ist, **dadurch gekennzeichnet, daß** die Zone (32, 33) des anderen Leistungstyps mit Kontakten (311, 312, 313, 314, 321, 322, 323, 324) zur Einspeisung eines Kompensationsstroms (IK) versehen ist.

2. Hall-Sensor nach Anspruch 1,
bei dem das Hall-Plättchen (2) zwischen zwei Zonen (31, 33) des anderen Leitungstyps angeordnet ist.

3. Hall-Sensor nach Anspruch 1,
- bei dem das Hall-Plättchen (2) an der Oberfläche des Substrats (1) angeordnet ist, und
- bei dem die Zone (32) des anderen Leitungstyps in einem Substrat (1) vom Leitungstyp des Hall-Plättchens (2) eingebettet ist.

4. Verfahren zum Betrieb eines Hall-Sensors nach einem der Ansprüche 1 bis 3,
wobei ein Kompensationsstrom (IK) parallel zum Steuerstrom (IS) fließt, dessen Größe so bemessen ist, daß das Hall-Plättchen (2) eine im wesentlichen konstante Dicke (D) aufweist.

## Claims

1. Hall sensor on a semiconductor substrate (1),
- in which a Hall plate (2) is formed from a zone (33, 32) of one conduction type,
- in which provision is made of a zone (33, 32) which adjoins the Hall plate (2), is separated from the latter by a space charge zone (41) and is of the other conduction type,
- and in which the Hall plate is provided with contacts (311, 312, 313, 314, 321, 322, 323, 324) for feeding in a control current (IS), **characterized in that** the zone (32, 33) of the other conduction type is provided with contacts (311, 312, 313, 314, 321, 322, 323, 324) for feeding in a compensation current (IK).

2. Hall sensor according to Claim 1,
in which the Hall plate (2) is arranged between two zones (31, 33) of the other conduction type.

3. Hall sensor according to Claim 1,
- in which the Hall plate (2) is arranged on the surface of the substrate (1), and
- in which the zone (32) of the other conduction type is embedded in a substrate (1) of the conduction type of the Hall plate (2).

4. Method for operating a Hall sensor according to one of Claims 1 to 3,
a compensation current (IK) flowing parallel to the control current (IS), the magnitude of which is such that the Hall plate (2) has an essentially constant thickness (D).

## Revendications

1. Capteur Hall sur un substrat semi-conducteur (1):
- dans lequel une plaquette Hall (2) est formée par une zone (33, 32) d'un type de conduite,
- dans lequel on a prévu une zone (33, 32), de l'autre type de conduite, contiguë à la plaquette Hall (2) et séparée par une zone de chargement spatial (41) de ladite plaquette,
- et dans lequel la plaquette Hall est pourvue de contacts ( 311, 312, 313, 314, 312, 322, 323, 324) pour introduire un courant de commande (IS), **caractérisé en ce que** la zone (32, 33) de l'autre type de conduite est pourvue de contacts ( 311, 312, 313, 314, 312, 322, 323, 324) pour introduire un courant de compensation (IK).

2. Capteur Hall selon la revendication 1, dans lequel la plaquette Hall (2) est disposée entre deux zones (31, 33) de l'autre type de conduite.

3. Capteur Hall selon la revendication 1,
- dans lequel la plaquette Hall (2) est disposée sur la surface du substrat (1),
- dans lequel la zone (32) de l'autre type de conduite est noyée dans un substrat (1) du type de conduite de la plaquette Hall (2).

4. Procédé pour faire fonctionner un capteur Hall selon une des revendications 1 à 3, où un courant de compensation (IK) s'écoule parallèlement au courant de commande (IS), dont la magnitude est dimensionnée de manière à ce que la plaquette Hall (2) présente une épaisseur (D) essentiellement constante.
